# EUROPÄISCHE PATENTANMELDUNG

(11) **EP 3 859 375 A1**
(43) Veröffentlichungstag der Anmeldung: **04.08.2021**
(21) Anmeldenummer: 21153259.3
(22) Anmeldetag: 25.01.2021
(51) Int. Cl.: G01S 7/03, G01S 13/931, G01S 7/02, H01L 23/66, H01Q 1/32, H01Q 21/06

(54) **RADARANORDNUNG**

(30) Priorität: 28.01.2020 DE 102020102037
(71) Anmelder: Krohne Messtechnik GmbH, 47058 Duisburg (DE)
(72) Erfinder: Convent, Thomas, 47661 Issum (DE); Dahl, Christoph, 44799 Bochum (DE); Gerding, Michael, 44805 Bochum (DE); Schulz, Christian, 44791 Bochum (DE); Vogt, Michael, 44797 Bochum (DE)
(74) Vertreter: Gesthuysen Patentanwälte

(57) **Zusammenfassung**

Dargestellt und beschrieben ist eine Radaranordnung (1) mit einer Platine (2), wenigstens einer elektronischen Komponente (3) und wenigstens einer Antenne (4), wobei die elektronische Komponente (3) auf der Platine (2) angeordnet ist und zumindest zur Erzeugung eines Hochfrequenzsignals dient, mit wenigstens einer von der Platine (2) umfassten Leitungsstruktur (5) zur Führung des Hochfrequenzsignals von der elektronischen Komponente (3) in den Bereich der Antenne (4), wobei die Leitungsstruktur (5) das Hochfrequenzsignal an einem offen endenden Abstrahlbereich (6) abstrahlt und die Antenne (4) mit dem abgestrahlten Hochfrequenzsignal beaufschlagt.

Eine kompakte Radaranordnung (1) mit Möglichkeit zur Prozesstrennung wird dadurch erreicht, dass die Platine (2) mindestens vier im Wesentlichen parallel zueinander verlaufende elektrisch leitfähige Lagen (8, 9, 10, 11) aufweist, die von wenigstens drei elektrisch isolierenden Lagen (12, 13, 14) voneinander getrennt sind, sodass zwei Außenlagen (8, 11) der Platine (2), die erste Außenlage (8) und die zweite Außenlage (11), durch zwei elektrisch leitfähige Lagen (9, 10) der mindestens vier elektrisch leitfähigen Lagen (8, 9, 10, 11) gebildet sind und die verbleibenden mindestens zwei elektrisch leitfähigen Lagen (9, 10) elektrisch leitfähige Innenlagen (9, 10) der Platine (2) bilden, wobei die erste elektrisch leitfähige Innenlage (9) benachbart ist zur ersten elektrisch leitfähigen Außenlage (8) und wobei die zweite elektrisch leitfähige Innenlage (10) benachbart ist zur zweiten elektrisch leitfähigen Außenlage (11), und dass die wenigstens drei elektrisch isolierenden Lagen (12, 13, 14) sämtlich elektrisch isolierende Innenlagen (12, 13, 14) der Platine (2) bilden, dass die elektronische Komponente (3) auf der ersten elektrisch leitfähigen Außenlage (8) der Platine (2) angeordnet ist, dass die Antenne (4) zumindest teilweise in der zweiten Außenlage (11) der Platine (2) ausgebildet ist, und dass das von der elektronischen Komponente (3) erzeugte Hochfrequenzsignal zu der in der zweiten elektrisch leitfähigen Außenlage (11) der Platine (2) zumindest teilweise ausgebildeten Antenne (4) durch den Bereich der elektrisch leitfähigen Innenlagen (9, 10) und elektrisch isolierenden Innenlagen (12, 13, 14) der Platine (2) übertragen wird.

## Beschreibung

Die Erfindung betrifft eine Radaranordnung mit einer Platine, wenigstens einer elektronischen Komponente und wenigstens einer Antenne, wobei die elektronische Komponente auf der Platine angeordnet ist und zumindest zur Erzeugung eines Hochfrequenzsignals dient, mit wenigstens einer von der Platine umfassten Leitungsstruktur zur Führung des Hochfrequenzsignals von der elektronischen Komponente in den Bereich der Antenne, wobei die Leitungsstruktur das Hochfrequenzsignal an einem offen endenden Abstrahlbereich abstrahlt und die Antenne mit dem abgestrahlten Hochfrequenzsignal beaufschlagt.

Die zuvor genannten Radaranordnungen sind aus dem Stand der Technik aus ganz unterschiedlichen Anwendungsbereichen seit Langem bekannt, beispielsweise aus der Füllstandmesstechnik oder auch aus dem automotiven Bereich. Radaranordnungen der beschriebenen Art verfügen oft nicht nur über eine einzige Antenne und eine einzige elektronische Komponente zur Erzeugung eines Hochfrequenzsignals, sondern können auch mehrere Antennen und elektronische Komponenten zur Erzeugung von verschiedenen - beispielsweise phasenverschobenen - Hochfrequenzsignalen aufweisen. So können Antennenfelder realisiert werden, wobei durch entsprechende Ansteuerung zum Beispiel phasenverschobene Hochfrequenzsignale auf elektronischem Wege erzeugt werden und so eine Richtungswirkung erzielt werden kann (Patchantennenfelder, Panelantennen).

Im Stand der Technik ist bekannt, dass die Antenne und die Leitungsstruktur auf der Seite der Platine angeordnet sind, auf der auch die elektronische Komponente zur Erzeugung des Hochfrequenzsignals angeordnet ist. Vorteil dieser Anordnung ist ein relativ einfaches Hochfrequenzdesign auf nur einer Platinenebene und die Realisierung von einfachen Antennenstrukturen. Nachteile ergeben sich hier bezüglich der teilweise erforderlichen Prozesstrennung, da die Elektronik auf der Antennenseite angeordnet ist und damit auch auf der dem zu überwachenden Prozess zugewandten Seite der Platine. Auch ergeben sich möglicherweise Probleme hinsichtlich der Anforderungen des Explosionsschutzes.

Aufgabe der vorliegenden Erfindung ist deshalb, eine Radaranordnung anzugeben, bei der die aufgezeigten Nachteile aus dem Stand der Technik zumindest teilweise vermieden werden.

Die hergeleitete Aufgabe ist bei der eingangs beschriebenen Radaranordnung zunächst und im Wesentlichen dadurch gelöst, dass die Platine mindestens vier im Wesentlichen parallel zueinander verlaufende elektrisch leitfähige Lagen aufweist, die von wenigstens drei elektrisch isolierenden Lagen voneinander getrennt sind, sodass zwei elektrisch leitfähige Außenlagen der Platine, die erste elektrisch leitfähige Außenlage und die zweite elektrisch leitfähige Außenlage, durch zwei elektrisch leitfähige Lagen der mindestens vier elektrisch leitfähigen Lagen gebildet sind und die verbleibenden mindestens zwei elektrisch leitfähigen Lagen elektrisch leitfähige Innenlagen der Platine bilden, wobei die erste elektrisch leitfähige Innenlage benachbart ist zur ersten elektrisch leitfähigen Außenlage und wobei die zweite elektrisch leitfähige Innenlage benachbart ist zur zweiten elektrisch leitfähigen Außenlage, und dass die wenigstens drei elektrisch isolierenden Lagen sämtlich elektrisch isolierende Innenlagen der Platine bilden. Im Ergebnis ergibt sich also in Richtung der Flächennormalen der parallel zueinander verlaufenden Lagen der Platine gesehen der Aufbau: erste elektrisch leitfähige Außenlage, elektrisch isolierende Innenlage, erste elektrisch leitfähige Innenlage, weitere elektrisch isolierende Innenlage, zweite elektrisch leitfähige Innenlage, weitere elektrisch isolierende Innenlage und zweite elektrisch leitfähige Außenlage. Sollten noch weitere elektrisch leitfähige Lagen realisiert sein, bleibt es jedoch bei dem Aufbau, dass die erste und die zweiten elektrisch leitfähigen Lagen elektrisch leitfähige Außenlage der Platine bilden und sämtliche elektrisch isolierenden Lagen elektrisch isolierende Innenlagen bilden; es gibt also immer eine elektrisch isolierende Lage weniger als es elektrisch leitfähige Lagen gibt.

Darüber hinaus zeichnet sich die erfindungsgemäße Radaranordnung dadurch aus, dass die elektronische Komponente auf der ersten Außenlage der Platine angeordnet ist, die demzufolge die Bestückungsseite der Platine bildet. Ferner ist erfindungsgemäß die Antenne zumindest teilweise in der zweiten elektrisch leitfähigen Außenlage der Platine ausgebildet, also üblicherweise als ein sogenannter Patch, dessen Abmessungen von der Wellenlänge des zu emittierenden Hochfrequenzsignals abhängt. Insgesamt wird bei der erfindungsgemäßen Radaranordnung das von der elektronischen Komponente erzeugte Hochfrequenzsignal zu der in der zweiten Außenlage der Platine zumindest teilweise ausgebildeten Antenne durch den Bereich der elektrisch leitfähigen und elektrisch isolierenden Innenlage der Platine übertragen. Über die Antenne wird das Hochfrequenzsignal dann letztendlich in den Außenraum abgestrahlt.

Der beschriebene Aufbau hat den Vorteil, dass eine strikte Trennung zwischen der Prozessseite, also der Seite, auf der die Antenne realisiert ist, und der Bestückungsseite, also der Seite, auf der die elektronische Komponente angeordnet ist - oder auch mehrere elektronische Komponenten angeordnet sind -, erreicht wird. Durch diese Trennung lassen sich besonders kompakte Designs realisieren, insbesondere auch dann, wenn die Radaranordnung über mehrere Antennen und mehrere elektronische Komponenten verfügt.

Wenn bei dem Platinenaufbau von verschiedenen elektrisch leitfähigen Lagen die Rede ist, dann bedeutet das selbstverständlich nicht, dass die elektrisch leitfähigen Lagen durchgehend leitfähig sind, also durchgehende Metallschichten bilden, denn mit diesem Verständnis könnte eine Radaranordnung natürlich nicht realisiert werden. Das fachmännische Verständnis ist, dass innerhalb der der elektrisch leitfähigen Lagen auch Strukturen ausgebildet sein können, die elektrisch nicht leitfähig sind, beispielsweise indem in den betreffenden Bereichen eine Metallisierung nicht vorgenommen worden ist oder die leitfähige Lage entfernt worden ist. Das ist das übliche und fachmännische Verständnis der sinnvollen Realisierung von mehrlagigen Platinen. In den jeweiligen elektrisch leitfähigen Lagen können also verschiedene leitfähige Strukturen aufgebaut sein, die elektrisch voneinander isoliert sind.

In einer bevorzugten Ausgestaltung der Radaranordnung ist vorgesehen, dass die elektrisch isolierenden Lagen eine Dicke 50 µm bis 200 µm aufweisen, insbesondere eine Schichtdicke zwischen 90 µm und 110 µm aufweisen. Vorzugsweise ist weiterhin vorgesehen, dass die elektrisch isolierenden Lagen aus einem Hochfrequenzsubstrat bestehen, dass eine geringe Dämpfung für elektromagnetische Wellen bei Frequenzen des Hochfrequenzsignals hat. Dadurch ist gewährleistet, dass die von dem Abstrahlbereich der Leitungsstruktur abgestrahlten Hochfrequenzsignale möglichst ungedämpft durch die Platine übertragen werden können, was natürlich voraussetzt, dass in dem entsprechenden Bereich die elektrisch leitfähigen Lagen Ausnehmungen aufweisen, in denen also die elektrisch leitfähige Schicht nicht ausgebildet ist.

Gemäß einer weiteren vorteilhaften Ausgestaltung ist vorgesehen, dass die elektrisch leitfähigen Innenlagen eine Schichtdicke von 10 µm bis 30 µm aufweisen, insbesondere eine Schichtdicke von 15 µm bis 21 µm aufweisen, wobei die elektrisch leitfähigen Innenlagen vorzugsweise aus Kupfer gebildet sind. Diese Schichtdicken erlauben die Ausbildung von für die vorliegenden Zwecke ausreichende Leitungsstrukturen innerhalb der elektrisch leitfähigen Innenlagen.

Besonders bevorzugt ist vorgesehen, dass die elektrisch leitfähigen Außenlagen eine Schichtdicke von 15 µm bis 60 µm aufweisen, insbesondere eine Schichtdicke von 40 µm bis 55 µm , wobei die elektrisch leitfähigen Außenlagen vorzugsweise ebenfalls aus Kupfer gebildet sind. Vorzugsweise wird die größere Schichtdicke der elektrisch leitfähigen Außenlagen gegenüber den Schichtdicken der elektrisch leitfähigen Innenlagen dadurch erzielt, dass alle elektrisch leitfähigen Lagen zunächst gleich dick ausgestaltet sind und auf die elektrisch leitfähigen Außenlagen dann eine weitere Kupferschicht aufgalvanisiert wird. Das Aufgalvanisieren geschieht beispielsweise infolge der Herstellung elektrisch leitfähiger Durchkontaktierungen in der Platine, wobei zusätzliches leitfähiges Material auf die Wandungen von Durchgangslöchern in der Platine aufgalvanisiert wird, sodass entsprechende Materialstärken dann auch auf den bereits existenten elektrisch leitfähigen Außenlagen abgeschieden werden und zu deren Verdickung beitragen.

Wenn mit den zuvor angegebenen Schichtdicken gearbeitet wird, dann ergibt sich insgesamt ein Platinenaufbau, der flexibel und mechanisch nicht sonderlich stabil ist, sodass beispielsweise auch die Bestückung der Platine mit elektronischen Bauelementen auf der Bestückungsseite, also auf der ersten elektrisch leitfähigen Außenlage, problematisch sein kann. Aus diesem Grund ist in einer bevorzugten Ausgestaltung weiterhin vorgesehen, dass auf der zweiten elektrisch leitfähigen Außenlage eine Versteifungslage befestigt ist, insbesondere die Versteifungslage auf die zweite elektrisch leitfähige Außenlage laminiert oder geklebt ist, wobei die Versteifungslage vorzugsweise aus einem metallisierten Nichtmetall oder aus einem Metall besteht. Das Nichtmetall ist vorzugsweise ein Verbundwerkstoff, vorzugsweise ein Verbundwerkstoff aus Glasfasergewebe und Epoxidharz, beispielsweise FR-4. Dadurch erlangt die Platine einen mechanisch stabilen Aufbau, der sowohl die Handhabung bei der Herstellung - also beispielsweise auch bei der Bestückung - der Platine vereinfacht, der aber auch dem Einsatz der Platine in robusten Umgebungen ermöglicht. Vorzugsweise ist die Metallisierung auf beiden Seiten der Versteifungslage vorgesehen, alternativ ist die Metallisierung nur auf der Außenseite der Versteifungslage vorgesehen, also nicht auf der Verbindungsseite der Versteifungslage mit der zweiten elektrisch leitfähigen Außenlage.

Um eine hinreichende Stabilität der Platine insgesamt zu erreichen, ist vorzugsweise vorgesehen, dass die Versteifungslage eine Dicke von 0,5 mm bis 0,9 mm aufweist, insbesondere eine Dicke zwischen 0,6 mm und 0,8 mm aufweist.

Eine weitere bevorzugte Ausgestaltung der Radaranordnung zeichnet sich dadurch aus, dass die Versteifungslage im Bereich der in der zweiten leitfähigen Außenlage zumindest teilweise ausgebildeten Antenne eine Ausnehmung aufweist, insbesondere wobei die Berandungskante der Ausnehmung metallisiert ist. Dadurch wird in einem gewissen Umfang die Abstrahlcharakteristik der Antenne beeinflusst, beispielsweise kann eine bessere Richtwirkung erzielt werden als ohne die vorgeschlagene Ausgestaltung der Versteifungslage.

Eine weitere bevorzugte Ausgestaltung der Radaranordnung ist dadurch gekennzeichnet, dass in drei der elektrisch leitfähigen Lagen in Richtung der Flächennormalen der elektrisch leitfähigen Lagen von der ersten Außenlage zu der zweiten Außenlage gesehen realisiert sind: der Abstrahlbereich der Leitungsstruktur zur Führung des Hochfrequenzsignals, eine Fein-Apertur zum definierten Durchlass der von dem Abstrahlbereich der Leitungsstruktur emittierten elektromagnetischen Strahlung und die Antenne in der zweiten elektrisch leitfähigen Außenlage. Insgesamt wird so also eine apertur-gekoppelte Patchantenne realisiert. Die von dem Abstrahlbereich der Leitungsstruktur emittierten elektromagnetischen Wellen gelangen durch die Fein-Apertur, die nichts anderes als eine vorzugsweise schlitzförmige Öffnung innerhalb der betreffenden elektrisch leitfähigen Lage darstellt, zu der Antenne in der zweiten elektrisch leitfähigen Außenlage, die dann entsprechend der Anregungen eine elektromagnetische Welle in den Freiraum abgibt. Der Abstrahlbereich der Leitungsstruktur, die Fein-Apertur und die Antenne in der zweiten elektrisch leitfähigen Außenlage können geometrisch aufeinander abgestimmt werden, um bestimmte Anforderungen hinsichtlich Polarisation, Bandbreite und Abstrahlcharakteristik zu erfüllen, was jedoch im Detail nicht Gegenstand der vorliegenden Erfindung ist.

Eine bevorzugte Ausgestaltung der zuvor beschriebenen apertur-gekoppelten Antenne besteht darin, dass der Abstrahlbereich der Leitungsstruktur zur Führung des Hochfrequenzsignals in der ersten elektrisch leitfähigen Außenlage realisiert ist, die Fein-Apertur in der ersten elektrisch leitfähigen Innenlage realisiert ist, eine Grob-Apertur in der zweiten elektrisch leitfähigen Innenlage realisiert ist, wobei die Grob-Apertur größer ist als die Fein-Apertur und dem ungehinderten Durchlass der durch die Fein-Apertur hindurchtretenden elektromagnetischen Strahlung zur in der zweiten elektrisch leitfähigen Außenlage zumindest teilweise ausgebildeten Antenne dient. Die Grob-Apertur ist deutlich größer ausgebildet als die Fein-Apertur und stellt gegenüber der Fein-Apertur einfach nur einen großflächigen Durchlass der von der Fein-Apertur geformten elektromagnetischen Strahlung dar, um auf diese Strahlung möglichst wenig Einfluss zu nehmen. Wenn die Leitungsstruktur als Streifenleitung oder Mikrostreifenleitung ausgeführt ist, dann stellt diese Streifenleitung in dem beschriebenen Aufbau eine asymmetrische Streifenleitung dar.

Eine alternative Ausgestaltung besteht darin, dass der Abstrahlbereich der Leitungsstruktur zur Führung des Hochfrequenzsignals in der ersten elektrisch leitfähigen Innenlage realisiert ist, die Fein-Apertur in der zweiten elektrisch leitfähigen Innenlage realisiert ist und dass die erste elektrisch leitfähige Außenlage im Abstrahlbereich der Leitungsstruktur zur Führung des Hochfrequenzsignals eine metallische Abschirmung realisiert. Wenn in diesem Aufbau die Leitungsstruktur als Streifenleitung realisiert ist, dann bildet sie in dieser Anordnung eine symmetrische Streifenleitung.

Solange die Radaranordnung nur eine einzige Antenne aufweist, die dann üblicherweise auch nur mit einem einzigen Hochfrequenzsignal gespeist wird, sind die zuvor beschriebenen Variationen der zugrunde liegenden Radaranordnung weitestgehend unproblematisch. Wenn jedoch innerhalb der Radaranordnung mehrere benachbarte Antennen realisiert werden sollen, die dann üblicherweise auch mit verschiedenen - insbesondere phasenverschobenen - Hochfrequenzsignalen gespeist werden, ist eine gegenseitige Beeinflussung benachbarter Antennen und der benachbarten Übertragungswege von der ersten elektrisch leitfähigen Außenlage zu der zweiten elektrischen leitfähigen Außenlage nicht auszuschließen und unerwünscht. Hier setzt eine bevorzugte Ausgestaltung der Radaranordnung an, die sich dadurch auszeichnet, dass mittels einer Vielzahl elektrischer Durchkontaktierungen zwischen den vier elektrisch leitfähigen Lagen eine gitterförmige elektromagnetische Abschirmung realisiert ist und zwar um den Abstrahlbereich der Leitungsstruktur zur Führung des Hochfrequenzsignals, um die Fein-Apertur zum definierten Durchlass der von der dem Abstrahlbereich der Leitungsstruktur emittierten elektromagnetischen Strahlung und um die Antenne in der zweiten elektrisch leitfähigen Außenlage und, soweit zutreffend, um die in der zweiten elektrisch leitfähigen Innenlage realisierte Grob-Apertur. Die resultierende Struktur aus gitterförmiger elektromagnetischer Abschirmung, Abstrahlbereich der Leitungsstruktur, Fein-Apertur und Antenne in der zweiten elektrisch leitfähigen Außenlage bildet so eine Elementarzelle. Durch die beschriebene Ausgestaltung ist es ohne Weiteres möglich, dass eine Vielzahl von Elementarzellen in der Radaranordnung ausgebildet sind, wobei diese Elementarzellen auch dicht an dicht ausgebildet werden können. Die elektrischen Durchkontaktierungen zwischen den vier elektrisch leitfähigen Lagen müssen so eng gewählt werden, dass die in jeder Elementarzelle transportierten elektromagnetischen Wellen die gitterförmige elektromagnetische Abschirmung nicht überwinden können.

Um eine möglichst hohe Dichte von Elementarzellen erzielen zu können, ist weiterhin vorzugsweise vorgesehen, dass die Abmessungen der gitterförmigen elektromagnetischen Abschirmung und damit der Elementarzelle maximal so gewählt ist, dass mehrere Elementarzellen auf einem vorzugsweise hexagonalem Gitter angeordnet werden können mit einem Abstand von einer halben bis einer ganzen Wellenlänge des abzustrahlenden Hochfrequenzsignals. Dabei kann vorgesehen sein, dass sich die gitterförmige elektromagnetische Abschirmungen von benachbarten Elementarzellen zumindest teilweise überschneiden, sprich zwei benachbarte Elementarzellen sich einen einzigen Abschnitt der gitterförmigen elektromagnetischen Abschirmung teilen.

Im Zusammenhang mit der Realisierung der gitterförmigen elektromagnetischen Abschirmung ist weiterhin vorteilhaft vorgesehen, dass die gitterförmige elektromagnetische Abschirmung und damit die Elementarzelle einen kreisförmigen oder hexagonalen Querschnitt hat, in Richtung der Flächennormalen der elektrisch leitfähigen Lagen gesehen.

Es gibt nun verschiedene Möglichkeiten, die erfindungsgemäße Radaranordnung auszugestalten und weiterzubilden. Dazu wird verwiesen auf die dem unabhängigen Patentanspruch nachgeordneten Patentansprüche und auf die nachfolgende Beschreibung von Ausführungsbeispielen in Verbindung mit der Zeichnung. In der Zeichnung zeigen
- Fig. 1: ein Ausführungsbeispiel für eine aus dem Stand der Technik bekannte Radaranordnung,
- Fig. 2: ein Ausführungsbeispiel für eine Platine für eine erfindungsgemäße Radaranordnung,
- Fig. 3: ein Ausführungsbeispiel für eine Platine für eine erfindungsgemäße Radaranordnung mit dickeren leitfähigen Außenlagen,
- Fig. 4: ein Ausführungsbeispiel einer Platine für eine erfindungsgemäße Radaranordnung mit einer Versteifungslage,
- Fig. 5: ein Ausführungsbeispiel für eine erfindungsgemäße Radaranordnung mit einer Ausnehmung in der Versteifungslage,
- Fig. 6: die Darstellung verschiedener elektrisch leitfähiger Lagen zur Realisierung einer erfindungsgemäßen Radaranordnung mit asymmetrischer Streifenleitung,
- Fig. 7: die Darstellung verschiedener elektrisch leitfähiger Lagen zur Realisierung einer erfindungsgemäßen Radaranordnung mit symmetrischer Streifenleitung,
- Fig. 8: ein Ausführungsbeispiel für eine Platine für eine erfindungsgemäße Radaranordnung mit elektrischen Durchkontaktierungen zwischen allen vier elektrisch leitfähigen Lagen und
- Fig. 9: ein Ausführungsbeispiel für eine erfindungsgemäße Radaranordnung mit mehreren Elementarzellen.

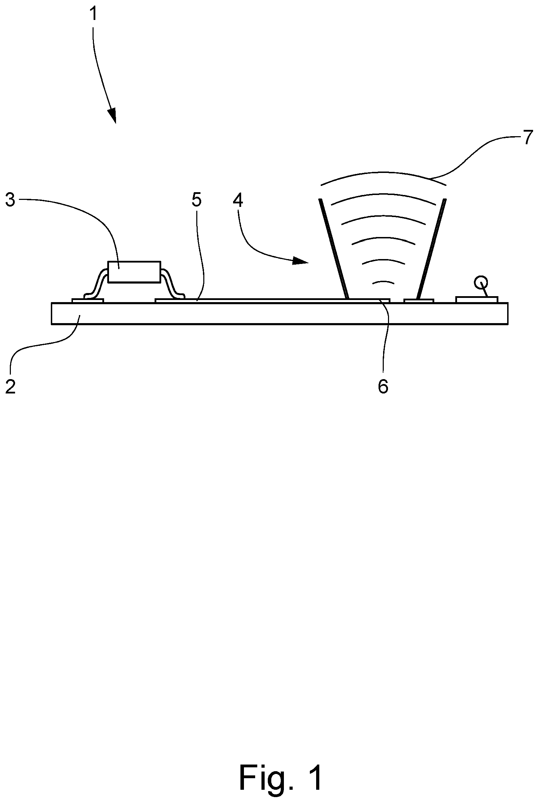

Fig. 1 zeigt eine Radaranordnung 1, wie sie aus dem Stand der Technik bekannt ist. Die Radaranordnung 1 weist eine Platine 2 auf und eine elektronische Komponente 3 und eine Antenne 4. Die elektronische Komponente 3 ist auf der Platine 2 angeordnet und dient zur Erzeugung eines Hochfrequenzsignals. Die Radaranordnung 1 weist darüber hinaus eine von der Platine 2 umfasste Leitungsstruktur 5 zur Führung des Hochfrequenzsignals von der elektronischen Komponente 3 in den Bereich der Antenne 4, wobei die Leitungsstruktur 5 das Hochfrequenzsignal an einem offen endenden Abstrahlbereich 6 abstrahlt und die Antenne 4 mit dem abgestrahlten Hochfrequenzsignal beaufschlagt.

In der schematischen Darstellung gemäß Fig. 1 umfasst die Antenne 4 auch ein Horn zur Formung und Führung der abgestrahlten elektromagnetischen Wellen 7, was jedoch nicht erforderlich ist zur Realisierung einer Antenne 4. Das Ausführungsbeispiel gemäß Fig. 1 ist auch insoweit eine schematische Darstellung, als dass die Abmessungen der dargestellten Komponenten nicht maßstabsgerecht gezeigt sind. Die Darstellung ist so gewählt, dass die Komponenten - das betrifft beispielsweise die Leitungsstruktur 5 - als solche erkennbar sind. Wichtig ist jedenfalls, dass in dem dargestellten Ausführungsbeispiel die Bestückungsseite der Platine 2, auf der sich also die elektronische Komponente 3 befindet, identisch ist mit der Seite, auf der die Antenne 4 realisiert ist.

Es ist einleuchtend, dass sich so sehr einfache Designs für die dargestellte Radaranordnung 1 realisieren lassen, jedoch ergeben sich hier Nachteile hinsichtlich einer gewünschten Prozesstrennung, auch lassen sich kompakte Entwürfe mit mehreren Antennen nur bedingt realisieren.

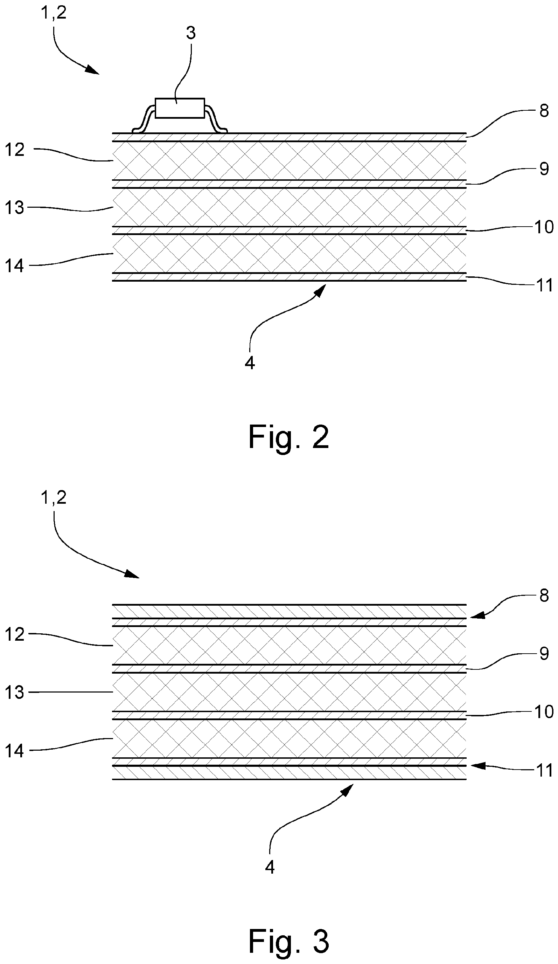

In den Fig. 2 bis 9 sind verschiedene Aspekte einer Radaranordnung 1 gezeigt, mit denen sich verschiedene Nachteile der Realisierung gemäß Fig. 1 vermeiden lassen.

Anhand des Ausführungsbeispiels gemäß Fig. 2 wird deutlich, dass die Platine 2 vier im Wesentlichen parallel zueinander verlaufende elektrisch leitfähige Lagen 8, 9, 10, 11 aufweist, die von wenigstens drei elektrisch isolierenden Lagen 12, 13, 14 voneinander getrennt sind. Wenn es heißt, dass die verschiedenen Lagen "im Wesentlichen" parallel zueinander verlaufen, dann ist damit gemeint, dass hier eine Parallelität nicht im mathematisch exakten Sinne gemeint ist, sondern soweit sich eine Parallelität im technisch sinnvollen Sinne - mit den üblichen technischen nicht vermeidbaren Ungenauigkeiten - realisieren lässt.

Zwei Außenlagen der Platine 8, 11, die erste elektrisch leitfähige Außenlage 8 und die zweite elektrisch leitfähige Außenlage 11, sind durch zwei elektrisch leitfähige Lagen 8, 11 der mindestens vier elektrisch leitfähigen Lagen 8, 9, 10, 11 gebildet und die verbleibenden mindestens zwei elektrisch leitfähigen Lagen 9, 10 bilden elektrisch leitfähige Innenlagen 9, 10 der Platine 2. Die erste elektrisch leitfähige Innenlage 9 ist benachbart zur ersten elektrisch leitfähigen Außenlage 8 und die zweite elektrisch leitfähige Innenlage 10 ist benachbart zur zweiten elektrisch leitfähigen Außenlage 11. Die drei elektrisch isolierenden Lagen 12, 13, 14 sind sämtlich elektrisch isolierende Innenlagen 12, 13, 14 der Platine 2.

Die elektronische Komponente 3 ist auf der ersten Außenlage 8 der Platine 2, also der Bestückungsseite, angeordnet und die Antenne 4 ist in der zweiten Außenlage 11 der Platine, also der Antennenseite, ausgebildet. Das von der elektronischen Komponente 3 erzeugte Hochfrequenzsignal wird also zu der in der zweiten Außenlage 11 der Platine 2 ausgebildeten Antenne durch den Bereich der elektrisch leitfähigen und elektrisch isolierenden Innenlagen 9, 10, 12, 13, 14 der Platine 2 übertragen. Die Darstellung in Fig. 2 ist sehr schematisch. Wie später noch anhand angegebener Schichtdicken erkennbar wird, müsste die elektronische Komponente 3 erheblich größer dargestellt werden, nämlich etwa in der Größenordnung der Gesamtschichtdicke der hier dargestellten Platine 2.

Die Darstellung in Fig. 2 ist auch dahingehend schematisch, als dass nicht ausdrücklich dargestellt ist, wie die Antenne 4 in der zweiten elektrisch leitfähigen Außenlage 11 ausgebildet ist und wie die elektrisch leitfähigen Innenlagen 9,10 der Platine 2 strukturiert sind, damit das von der elektronischen Komponente 3 erzeugte Hochfrequenzsignal von der ersten elektrisch leitfähigen Außenlager 8 zu der in der zweiten elektrisch leitfähigen Außenlager 11 bzw. zu der darin ausgebildeten Antenne 4 gelangen kann. Dies wäre natürlich nicht möglich, wenn die elektrisch leitfähigen Innenlagen 9,10 keine Unterbrechungen aufwiesen. Dies trifft auch auf die Darstellungen in den Fig. 3 bis 4 zu, auch hier sind die Schnitte nicht in den Bereichen vorgenommen worden, in denen die in den elektrisch leitenden Innenlagen 9, 10 erforderlichen Unterbrechungen realisiert sind. Wichtig ist in den Fig. 2 bis 4, dass der Aufbau der Platine 2 deutlich wird.

Bei den dargestellten Ausführungsbeispielen der Radaranordnung 1 in den Fig. 2 bis 9 weisen die elektrisch isolierenden Lagen 12, 13, 14 eine Dicke von etwa 100 µm auf und bestehen aus einem Hochfrequenzsubstrat, das eine geringe Dämpfung für elektromagnetische Wellen bei Frequenzen des von der elektronischen Komponente 3 erzeugten Hochfrequenzsignals hat. Die elektrisch leitfähigen Lagen 8, 9, 10, 11 in dem Ausführungsbeispiel gemäß Fig. 2 haben eine einheitliche Stärke von etwa 18 µm, also auch die elektrisch leitfähigen Außenanlagen 8, 11.

Demgegenüber haben die elektrisch leitfähigen Außenlagen 8, 11 bei dem Ausführungsbeispiel gemäß Fig. 3 eine Schichtdicke von etwa 43 µm, sie sind ebenfalls aus Kupfer gebildet. Die größere Schichtdicke der elektrisch leitfähigen Außenanlagen 8, 11 ist dadurch erzielt worden, dass auf eine zunächst vorhandene leitfähige Kupferschicht mit der Dicke der elektrisch leitfähigen Innenlagen 9, 10 Kupfer aufgalvanisiert worden ist, bis die genannte Schichtdicke der elektrisch leitfähigen Außenanlagen 8, 11 erreicht worden ist. Die Verhältnisse der Schichtdicken der verschiedenen elektrisch leitfähigen Lagen 8, 9, 10, 11 und der elektrisch isolierenden Lagen 12, 13, 14 sind in den Fig. 2 bis 5 in etwa richtig wiedergegeben.

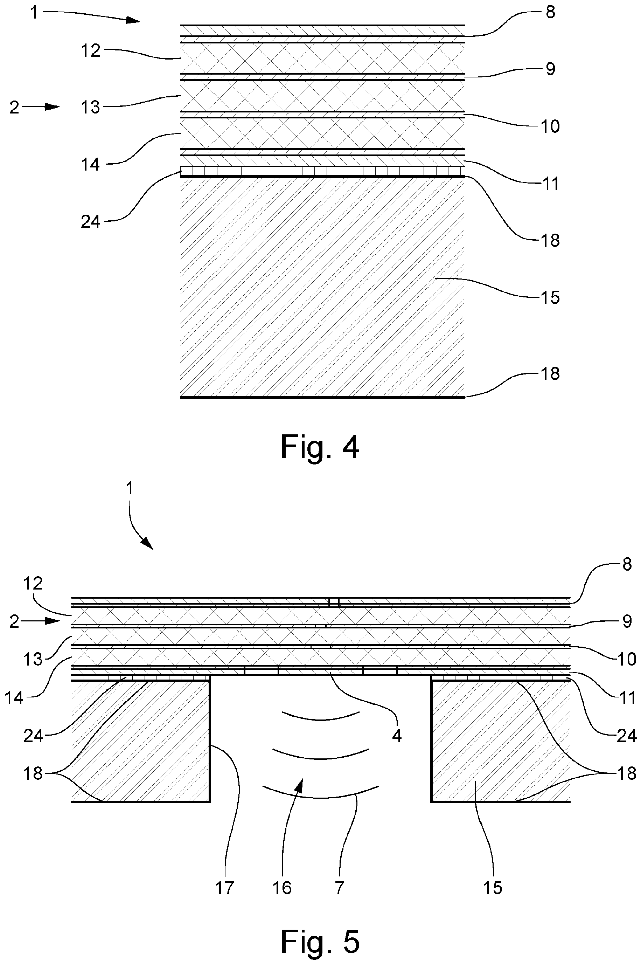

Bei den Ausführungsbeispielen der Radaranordnung 1 gemäß den Fig. 4 und 5 ist auf der zweiten elektrisch leitfähigen Außenlage 11 eine Versteifungslage 15 befestigt, wobei die Versteifungslage 15 auf die zweite elektrisch leitfähige Außenlage 11 mittels Klebschicht 24 geklebt ist. Die Klebschicht 24 hat hier eine Dicke von etwa 30 µm. Die Versteifungslage 15 besteht aus einem metallisierten Nichtmetall, wobei das Nichtmetall ein Verbundwerkstoff ist, vorliegend ein Verbundwerkstoff aus Glasfasergewebe und Epoxidharz, nämlich FR-4. Die Versteifungslage 15 ist beidseitig mit einer Metallisierung 18 versehen. Die Versteifungslage 15 weist hier eine Dicke von 0,7 mm auf. Da die Klebschicht 24 im vorliegenden Fall elektrisch leitfähig ist, bilden die zweite elektrisch leitfähige Außenlage 11, die Klebschicht 24 und die Metallisierung 18 eine elektrisch leitfähige Einheit. Selbst wenn die Klebschicht 24 nicht elektrisch leitfähig ist, bildet der sich dann entstehende Kondensator aus der zweiten elektrisch leitfähige Außenlage 11, der elektrisch isolierenden Klebschicht 24 und der Metallisierung 18 im Betriebsfall elektrisch gesehen einen Kurzschluss aufgrund der hohen Frequenzen der elektromagnetischen Strahlung, die im Radarbereich üblich ist.

In Fig. 5 ist in der Versteifungslage 15 im Bereich der in der zweiten leitfähigen Außenlage 11 ausgebildeten Antenne 4 eine Ausnehmung 16 ausgebildet, wodurch eine Berandungskante 17 entsteht. Die Berandungskante 17 der Ausnehmung 15 ist mit einer Metallisierung 18 versehen und daher metallisiert. Die metallisierte Berandungskante 17 nimmt damit Einfluss auf die Richtwirkung der Radaranordnung 1.

In Fig. 5 ist auch erstmalig dargestellt, wie die Antenne 4 in der zweiten elektrisch leitfähigen Außenlage 11 realisiert ist, nämlich indem die zweite elektrisch leitfähige Außenlage 11 mit entsprechenden Unterbrechungen versehen ist, wodurch die Antenne 4 in der zweiten elektrisch leitfähigen Außenlager 11 freigelegt ist.

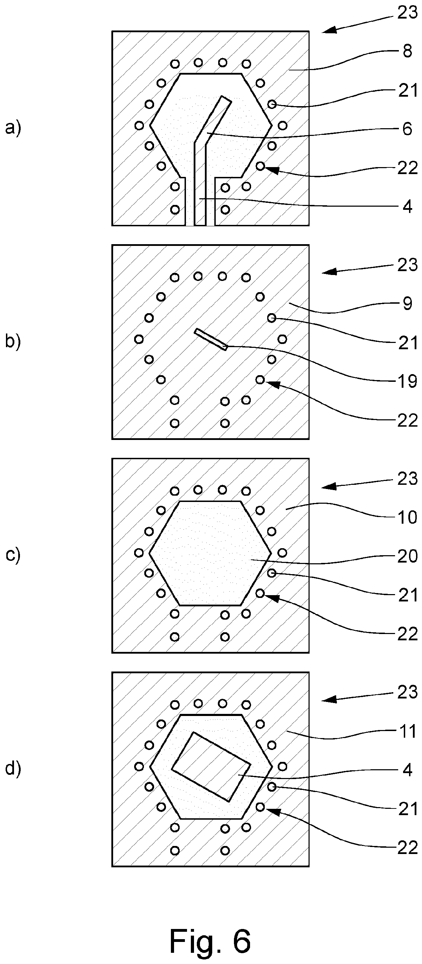

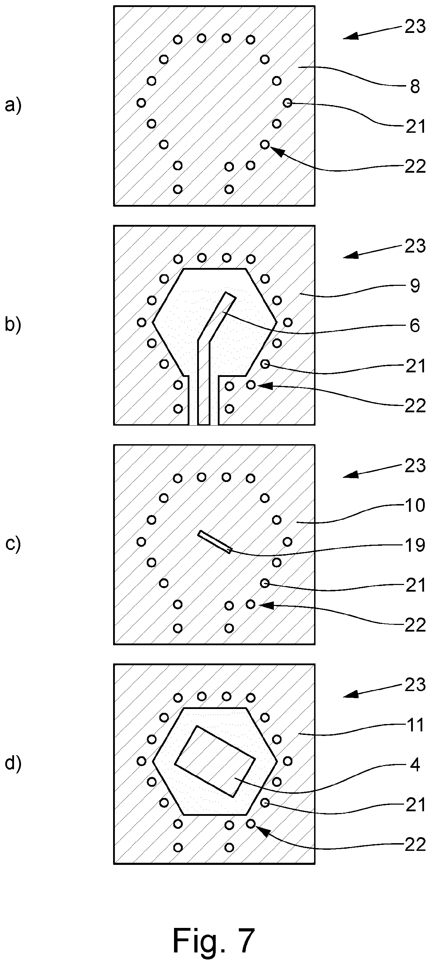

In den Fig. 6 und 7 sind zwei verschiedene Ausgestaltungen mit konkreten Geometrien gezeigt, die angeben, wie Radaranordnungen 1 vorteilhaft realisiert werden können. Dargestellt sind jeweils nur die elektrisch leitfähigen Lagen 8, 9, 10, 11, wobei von oben nach unten dargestellt sind die erste elektrisch leitfähige Außenlage 8, die erste elektrisch leitfähige Innenlage 9, die zweite elektrisch leitfähige Innenlage 10 und die zweite elektrisch leitfähige Außenlage 11. Den Ausgestaltungen gemäß den Fig. 6 und 7 ist gemeinsam dass in drei der elektrisch leitfähigen Lagen 8, 9, 10, 11 in Richtung der Flächennormalen der elektrisch leitfähigen Lagen 8, 9, 10, 11 von der ersten elektrisch leitfähigen Außenlage 8 zu der zweiten elektrisch leitfähigen Außenlage 11 gesehen realisiert sind: der Abstrahlbereich 6 der Leitungsstruktur 5 zur Führung des Hochfrequenzsignals, eine Fein-Apertur 19 zum definierten Durchlass der von dem Abstrahlbereich 6 der Leitungsstruktur 5 emittierten elektromagnetischen Strahlung 7 und die Antenne 4 in der zweiten elektrisch leitfähigen Außenlage 11. Die Ausführungsbeispiele in den Fig. 6 und 7 realisieren also jeweils eine apertur-gekoppelte Patchantenne.

Bei dem Ausführungsbeispiel gemäß Fig. 6 ist der Abstrahlbereich 6 der Leitungsstruktur 5 zur Führung des Hochfrequenzsignals in der ersten elektrisch leitfähigen Außenlage 8 realisiert (Fig. 6a), ist die Fein-Apertur 19 in der ersten elektrisch leitfähigen Innenlage 9 realisiert (Fig. 6b) und ist eine Grob-Apertur 20 in der zweiten elektrisch leitfähigen Innenlage 10 realisiert (Fig. 6c). Die Grob-Apertur 20 ist größer als die Fein-Apertur 19 und dient dem ungehinderten Durchlass der durch die Fein-Apertur 19 hindurchtretenden elektromagnetischen Strahlung 7 zur in der zweiten elektrisch leitfähigen Außenlage 11 ausgebildeten Antenne 4 (Fig. 6d).

Bei dem Ausführungsbeispiel gemäß Fig. 7 ist hingegen der Abstrahlbereich 6 der Leitungsstruktur 5 zur Führung des Hochfrequenzsignals in der ersten elektrisch leitfähigen Innenlage 9 realisiert und ist die Fein-Apertur 19 in der zweiten elektrisch leitfähigen Innenlage 10 realisiert. Die erste elektrisch leitfähige Außenlage 8 ist im Abstrahlbereich 6 der Leitungsstruktur 5 zur Führung des Hochfrequenzsignals als eine metallische Abschirmung ausgebildet. Da die Leitungsstruktur 5 hier als Streifenleitung ausgebildet ist, realisiert die Ausgestaltung gemäß Fig. 7 eine symmetrische Streifenleitung aufgrund der beidseitigen Abschirmung durch die erste elektrisch leitfähige Außenlage 8 und die zweite elektrisch leitfähige Innenlage 10 mit Ausnahme der Fein-Apertur 19.

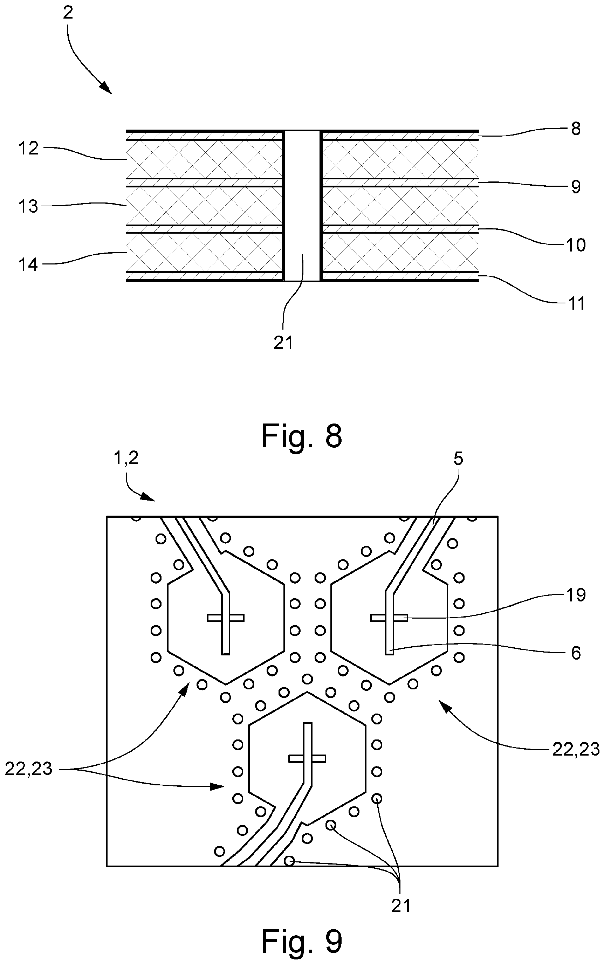

In Fig. 8 ist eine Besonderheit der Radaranordnungen gemäß den Fig. 6, 7 und 9 dargestellt, nämlich eine elektrische Durchkontaktierung 21 zwischen den vier elektrisch leitfähigen Lagen 8, 9, 10, 11, die sich natürlich auch durch die drei elektrisch isolierenden Lagen 12, 13, 14 erstreckt. Durch die Durchkontaktierung werden alle elektrisch leitfähigen Lagen 8, 9, 10, 11 elektrisch miteinander verbunden. Die elektrische Durchkontaktierung 21 ist hier eine Bohrung mit einer metallisierten Innenwandung. Derartige Durchkontaktierungen 21 sind in einer Vielzahl in den Ausführungsbeispielen gemäß den Fig. 6, 7 und 9 realisiert.

Mittels dieser Vielzahl elektrischer Durchkontaktierungen 21 zwischen den vier elektrisch leitfähigen Lagen 8, 9, 10, 11 wird eine gitterförmige elektromagnetische Abschirmung 22 realisiert, nämlich um den Abstrahlbereich 6 der Leitungsstruktur 5 zur Führung des Hochfrequenzsignals, um die Fein-Apertur 19 zum definierten Durchlass der von der dem Abstrahlbereich 6 der Leitungsstruktur 5 emittierten elektromagnetischen Strahlung 7 und um die Antenne 4 in der zweiten elektrisch leitfähigen Außenlage 11 und, soweit zutreffend (Ausführungsbeispiel gemäß Fig. 6), um die in der zweiten elektrisch leitfähigen Innenlage 10 realisierte Grob-Apertur 20, sodass die resultierende Struktur aus gitterförmiger elektromagnetischer Abschirmung 22, Abstrahlbereich 6 der Leitungsstruktur 5, Fein-Apertur 19 und Antenne 4 in der zweiten elektrisch leitfähigen Außenlage 11 eine Elementarzelle 23 bildet.

In den Fig. 6 und 7 ist demnach jeweils auch schichtweise der Aufbau einer gitterförmigen elektromagnetischen Abschirmung 22 und auch einer Elementarzelle 23 dargestellt. Die gitterförmige elektromagnetische Abschirmung 22 und damit die Elementarzelle 23 haben einen hexagonalen Querschnitt in Richtung der Flächennormalen der elektrisch leitfähigen Lagen 8, 9, 10, 11 gesehen.

Fig. 9 zeigt schließlich die Realisierung mehrerer Elementarzellen 23 innerhalb einer Radaranordnung 1 und damit die Umsetzung eines Patchantennen-Feldes, mit dem - eine entsprechende Ansteuerung der verschiedenen Elementarzellen vorausgesetzt - auch die Richtwirkung der Radaranordnung 1 variiert werden kann. Die Betrachtungsweise ist hier von oben auf die erste elektrisch leitfähige Außenlage, in der die Leitungsstruktur 5 mit ihrem Abstrahlbereich 6 realisiert ist. Angedeutet ist noch die Fein-Apertur 19 in der darunterliegenden ersten elektrisch leitfähigen Innenlage. Die Abmessungen der gitterförmigen elektromagnetischen Abschirmungen 22 und damit der Elementarzelle 23 sind so gewählt, dass mehrere Elementarzellen 23 auf einem hexagonalem Gitter angeordnet werden können mit einem Abstand von einer ganzen Wellenlänge des abgestrahlten Hochfrequenzsignals.

### Bezugszeichen

- 1: Radaranordnung
- 2: Platine
- 3: elektronische Komponente
- 4: Antenne
- 5: Leitungsstruktur
- 6: Abstrahlbereich der Leitungsstruktur
- 7: elektromagnetische Wellen
- 8: erste elektrisch leitfähige Außenanlage
- 9: erste elektrisch leitfähige Innenlage
- 10: zweite elektrisch leitfähige Innenlage
- 11: zweite elektrisch leitfähige Außenanlage
- 12: elektrisch isolierende Lage
- 13: elektrisch isolierende Lage
- 14: elektrisch isolierende Lage
- 15: Versteifungslage
- 16: Ausnehmung in der Versteifungslage
- 17: Berandungskante der Ausnehmung in der Versteifungslage
- 18: Metallisierung
- 19: Fein-Apertur
- 20: Grob-Apertur
- 21: elektrische Durchkontaktierung
- 22: gitterförmige elektromagnetische Abschirmung
- 23: Elementarzelle
- 24: Klebschicht

## Patentansprüche

1. Radaranordnung (1) mit einer Platine (2), wenigstens einer elektronischen Komponente (3) und wenigstens einer Antenne (4), wobei die elektronische Komponente (3) auf der Platine (2) angeordnet ist und zumindest zur Erzeugung eines Hochfrequenzsignals dient, mit wenigstens einer von der Platine (2) umfassten Leitungsstruktur (5) zur Führung des Hochfrequenzsignals von der elektronischen Komponente (3) in den Bereich der Antenne (4), wobei die Leitungsstruktur (5) das Hochfrequenzsignal an einem offen endenden Abstrahlbereich (6) abstrahlt und die Antenne (4) mit dem abgestrahlten Hochfrequenzsignal beaufschlagt,
**dadurch gekennzeichnet,**
**dass** die Platine mindestens vier im Wesentlichen parallel zueinander verlaufende elektrisch leitfähige Lagen (8, 9, 10, 11) aufweist, die von wenigstens drei elektrisch isolierenden Lagen (12, 13, 14) voneinander getrennt sind, sodass zwei Außenlagen (8, 11) der Platine (2), die erste Außenlage (8) und die zweite Außenlage (11), durch mindestens zwei elektrisch leitfähige Lagen (8, 9) der mindestens vier elektrisch leitfähigen Lagen (8, 9, 10, 11) gebildet sind und die verbleibenden mindestens zwei elektrisch leitfähigen Lagen (9, 10) elektrisch leitfähige Innenlagen (9, 10) der Platine (2) bilden, wobei die erste elektrisch leitfähige Innenlage (9) benachbart ist zur ersten elektrisch leitfähigen Außenlage (8) und wobei die zweite elektrisch leitfähige Innenlage (10) benachbart ist zur zweiten elektrisch leitfähigen Außenlage (11), und dass die wenigstens drei elektrisch isolierenden Lagen (12, 13, 14) sämtlich elektrisch isolierende Innenlagen (12, 13, 14) der Platine (2) bilden,
**dass** die elektronische Komponente (3) auf der ersten elektrisch leitfähigen Außenlage (8) der Platine (2) angeordnet ist,
**dass** die Antenne (4) zumindest teilweise in der zweiten Außenlage (11) der Platine (2) ausgebildet ist, und
**dass** das von der elektronischen Komponente (3) erzeugte Hochfrequenzsignal zu der in der zweiten elektrisch leitfähigen Außenlage (11) der Platine (2) zumindest teilweise ausgebildeten Antenne (4) durch den Bereich der elektrisch leitfähigen Innenlagen (9, 10) und elektrisch isolierenden Innenlagen (12, 13, 14) der Platine (2) übertragen wird.

2. Radaranordnung (1) nach Anspruch 1, **dadurch gekennzeichnet, dass** die elektrisch isolierenden Lagen (12, 13, 14) eine Dicke von 50 µm bis 200 µm aufweisen, insbesondere eine Schichtdicke zwischen 90 µm und 110 µm aufweisen.

3. Radaranordnung (1) nach Anspruch 1 oder 2, **dadurch gekennzeichnet, dass** die elektrisch isolierenden Lagen (12, 13, 14) aus einem Hochfrequenzsubstrat bestehen, das eine geringe Dämpfung für elektromagnetische Wellen bei Frequenzen des Hochfrequenzsignals hat.

4. Radaranordnung (1) nach einem der Ansprüche 1 bis 3, **dadurch gekennzeichnet, dass** die elektrisch leitfähigen Innenlagen (9, 10) eine Schichtdicke von 10 µm bis 30 µm aufweisen, insbesondere eine Schichtdicke von 15 µm bis 21 µm, wobei die elektrisch leitfähigen Innenlagen vorzugsweise aus Kupfer gebildet sind.

5. Radaranordnung (1) nach einem der Ansprüche 1 bis 4, **dadurch gekennzeichnet, dass** die elektrisch leitfähigen Außenlagen (8, 11) eine Schichtdicke von 15 µm bis 60 µm aufweisen, insbesondere eine Schichtdicke von 40 µm bis 55 µm, wobei die elektrisch leitfähigen Außenlagen (8, 11) vorzugsweise aus Kupfer gebildet sind.

6. Radaranordnung (1) nach einem der Ansprüche 1 bis 5, **dadurch gekennzeichnet, dass** auf der zweiten elektrisch leitfähigen Außenlage (11) eine Versteifungslage (15) befestigt ist, insbesondere die Versteifungslage (15) auf die zweite elektrisch leitfähige Außenlage (11) laminiert oder geklebt ist, wobei die Versteifungslage (15) vorzugsweise aus einem metallisierten Nichtmetall oder aus einem Metall besteht, wobei das Nichtmetall vorzugsweise ein Verbundwerkstoff ist, vorzugsweise ein Verbundwerkstoff aus Glasfasergewebe und Epoxidharz (FR4).

7. Radaranordnung (1) nach Anspruch 6, **dadurch gekennzeichnet, dass** die Versteifungslage (15) eine Dicke von 0,5 mm bis 0,9 mm aufweist, insbesondere eine Dicke zwischen 0,6 mm und 0,8 mm aufweist.

8. Radaranordnung (1) nach Anspruch 6 oder 7, **dadurch gekennzeichnet, dass** in der Versteifungslage (15) im Bereich der in der zweiten leitfähigen Außenlage (11) zumindest teilweise ausgebildeten Antenne (4) eine Ausnehmung (16) ausgebildet ist, insbesondere wobei die Berandungskante (17) der Ausnehmung (15) metallisiert ist.

9. Radaranordnung (1) nach einem der Ansprüche 1 bis 8, **dadurch gekennzeichnet, dass** in drei der elektrisch leitfähigen Lagen (8, 9, 10, 11) in Richtung der Flächennormalen der elektrisch leitfähigen Lagen (8, 9, 10, 11) von der ersten elektrisch leitfähigen Außenlage (8) zu der zweiten elektrisch leitfähigen Außenlage (11) gesehen realisiert sind: der Abstrahlbereich (6) der Leitungsstruktur (5) zur Führung des Hochfrequenzsignals, eine Fein-Apertur (19) zum definierten Durchlass der von dem Abstrahlbereich (6) der Leitungsstruktur (5) emittierten elektromagnetischen Strahlung (7) und die Antenne (4) in der zweiten elektrisch leitfähigen Außenlage (11).

10. Radaranordnung (1) nach Anspruch 9, **dadurch gekennzeichnet, dass** der Abstrahlbereich (6) der Leitungsstruktur (5) zur Führung des Hochfrequenzsignals in der ersten elektrisch leitfähigen Außenlage (8) realisiert ist, die Fein-Apertur (19) in der ersten elektrisch leitfähigen Innenlage (9) realisiert ist, eine Grob-Apertur (20) in der zweiten elektrisch leitfähigen Innenlage (10) realisiert ist, wobei die Grob-Apertur (20) größer ist als die Fein-Apertur (19) und dem ungehinderten Durchlass der durch die Fein-Apertur (19) hindurchtretenden elektromagnetischen Strahlung (7) zur in der zweiten elektrisch leitfähigen Außenlage (11) zumindest teilweise ausgebildeten Antenne (4) dient.

11. Radaranordnung (1) nach Anspruch 9, **dadurch gekennzeichnet, dass** der Abstrahlbereich (6) der Leitungsstruktur (5) zur Führung des Hochfrequenzsignals in der ersten elektrisch leitfähigen Innenlage (9) realisiert ist, die Fein-Apertur (19) in der zweiten elektrisch leitfähigen Innenlage (10) realisiert ist und dass die erste elektrisch leitfähige Außenlage (8) im Abstrahlbereich (6) der Leitungsstruktur (5) zur Führung des Hochfrequenzsignals eine metallische Abschirmung realisiert.

12. Radaranordnung (1) nach einem der Ansprüche 1 bis 11, **dadurch gekennzeichnet, dass** die Leitungsstruktur (5) zur Führung des Hochfrequenzsignals als Streifenleitung ausgebildet ist.

13. Radaranordnung (1) nach einem der Ansprüche 1 bis 11, **dadurch gekennzeichnet, dass** mittels einer Vielzahl elektrischer Durchkontaktierungen (21) zwischen den vier elektrisch leitfähigen Lagen (8, 9, 10, 11) eine gitterförmige elektromagnetische Abschirmung (22) realisiert ist um den Abstrahlbereich (6) der Leitungsstruktur (5) zur Führung des Hochfrequenzsignals, um die Fein-Apertur (19) zum definierten Durchlass der von der dem Abstrahlbereich (6) der Leitungsstruktur (5) emittierten elektromagnetischen Strahlung (7) und um die Antenne (4) in der zweiten elektrisch leitfähigen Außenlage (11) und, soweit zutreffend, um die in der zweiten elektrisch leitfähigen Innenlage (10) realisierte Grob-Apertur (20), sodass die resultierende Struktur aus gitterförmiger elektromagnetischer Abschirmung (22), Abstrahlbereich (6) der Leitungsstruktur (5), Fein-Apertur (19) und Antenne (4) in der zweiten elektrisch leitfähigen Außenlage (11) eine Elementarzelle (23) bildet.

14. Radaranordnung (1) nach Anspruch 13, **dadurch gekennzeichnet, dass** die gitterförmige elektromagnetische Abschirmung (22) und damit die Elementarzelle (23) einen kreisförmigen oder hexagonalen Querschnitt hat in Richtung der Flächennormalen der elektrisch leitfähigen Lagen (8, 9, 10, 11) gesehen.

15. Radaranordnung (1) nach Anspruch 13 oder 14, **dadurch gekennzeichnet, dass** die Abmessungen der gitterförmigen elektromagnetischen Abschirmung (22) und damit der Elementarzelle (23) maximal so gewählt ist, dass mehrere Elementarzellen (23) auf einem vorzugsweise hexagonalen Gitter angeordnet werden können mit einem Abstand von einer halben bis einer ganzen Wellenlänge des abgestrahlten Hochfrequenzsignals.
